# EUROPÄISCHE PATENTSCHRIFT

(11) **EP 3 820 809 B1**
(45) Veröffentlichungstag und Bekanntmachung des Hinweises auf die Patenterteilung: **07.09.2022**
(21) Anmeldenummer: 19724773.7
(22) Anmeldetag: 11.05.2019
(51) Int. Cl.: B81C 1/00

(54) **HERSTELLUNGSVERFAHREN FÜR EINE MIKROMECHANISCHE VORRICHTUNG MIT GENEIGTEN OPTISCHEN FENSTERN UND MIKROMECHANISCHE VORRICHTUNG MIT GENEIGTEN OPTISCHEN FENSTERN**
METHOD FOR PRODUCING A MICROMECHANICAL DEVICE WITH INCLINED OPTICAL WINDOWS AND MICROMECHANICAL DEVICE WITH INCLINED OPTICAL WINDOWS
PROCÉDÉ DE FABRICATION D'UN DISPOSITIF MICROMÉCANIQUE À FENÊTRES OPTIQUES INCLINÉES ET DISPOSITIF MICROMÉCANIQUE À FENÊTRES OPTIQUES INCLINÉES

(30) Priorität: 11.07.2018 DE 102018211548
(43) Veröffentlichungstag der Anmeldung: 19.05.2021
(73) Patentinhaber: Robert Bosch GmbH, 70442 Stuttgart (DE)
(72) Erfinder: PINTER, Stefan, 72764 Reutlingen (DE)
(86) Internationale Anmeldenummer: PCT/EP2019/062109
(87) Internationale Veröffentlichungsnummer: WO 2020/011422

(56) Entgegenhaltungen:
- DE-A1-102012 217 793
- DE-A1-102016 217 817

## Beschreibung

Die vorliegende Erfindung betrifft ein Herstellungsverfahren für eine mikromechanische Vorrichtung mit geneigten optischen Fenstern und eine mikromechanische Vorrichtung mit geneigten optischen Fenstern.

### Stand der Technik

Bei MEMS-Bauelementen muss üblicherweise zum Schutz vor schädlichen Außeneinflüssen durch Partikel oder Ähnlichem eine Schutzvorrichtung bereitgestellt werden, welcher das Bauelement vor mechanischer Berührung schützt und auch ein Prozessieren des Bauelements, etwa ein Vereinzeln aus einem Waferverbund in Chips durch Sägen ermöglicht, ohne Schaden zu nehmen. Schutzvorrichtungen mit optischen Fenstern weisen meist Grenzflächen an den Fenstern auf, an welchen unerwünschte Reflexionen entstehen können. Liegen solche ortsfesten Reflexe in einem Projektionsbereich des Bauelements, und übersteigt deren Intensität jene des zu projizierenden Lichts, kann dies störend wirken.

In der US 2007/0024549 werden dreidimensionale Oberflächenstrukturen als geneigte Fenster zur Vermeidung von Reflexen beschrieben, welche in einem Waferverbund herstellbar sind und mit Glas oder Kunststoff ein transparentes Material umfassen können.

Das Dokument DE 10 2016 217817 A1 beschreibt einen MEMS-Wafer, der mehrere Chips umfasst. Darüber befindet sich ein Schutzwafer mit geneigten optischen Fenstern. Dieser Schutzwafer umfasst eine Mehrzahl von Durchgangslöchern in einem ersten Substrat und in einem zweiten Substrat, wobei sich jeweils ein Durchgangsloch im ersten Substrat mit einem Durchgangsloch im zweiten Substrat deckungsgleich überdecken, sowie eine Fensterfolie welche zwischen dem ersten Substrat und dem zweiten Substrat angeordnet ist und das jeweilige Durchgangsloch bedeckt und im Bereich des Durchgangslochs ein um den Fensterwinkel abgeschrägtes optisches Fenster ausformt.

Das Dokument DE 10 2012 217793 A1 beschreibt ein Substrat mit einem abgeschrägten Randbereich. Das Fenster ist hierbei aus Glas ausgebildet.

### Offenbarung der Erfindung

Die vorliegende Erfindung schafft ein Herstellungsverfahren für eine mikromechanische Vorrichtung mit geneigten optischen Fenstern nach Anspruch 1 und eine mikromechanische Vorrichtung mit geneigten optischen Fenstern nach Anspruch 9.

Bevorzugte Weiterbildungen sind Gegenstand der Unteransprüche.

### Vorteile der Erfindung

Die der vorliegenden Erfindung zugrunde liegende Idee besteht darin, ein Herstellungsverfahren für eine mikromechanische Vorrichtung mit geneigten optischen Fenstern anzugeben, bei welchem störende Reflexionen in einem Projektionsbereich der Vorrichtung und/oder einer optischen Vorrichtung, welche mit der mikromechanischen Vorrichtung überdeckt werden kann, verringert oder vorteilhaft vermieden werden können, und welches eine hohe optische Güte mit geringen Herstellungskosten aufweist.

Erfindungsgemäß erfolgt bei dem Herstellungsverfahren für eine mikromechanische Vorrichtung mit geneigten optischen Fenstern in einem Verfahrensschritt S1 ein Bereitstellen eines ersten Substrats mit einer ersten Vorderseite und einer ersten Rückseite und eines zweiten Substrats mit einer zweiten Vorderseite und einer zweiten Rückseite. In einem weiteren Verfahrensschritt S2 erfolgt ein Erzeugen einer Mehrzahl von Durchgangslöchern im ersten Substrat und im zweiten Substrat derart, dass zu jedem Durchgangsloch im ersten Substrat ein deckungsgleiches Durchgangsloch im zweiten Substrat erzeugt wird, welche sich überdecken wenn das erste Substrat über dem zweiten Substrat angeordnet wird, wobei die erste Rückseite der zweiten Vorderseite zugewandt ist. In einem weiteren Verfahrensschritt S3 erfolgt ein Erzeugen eines abgeschrägten Randbereichs um ein jeweiliges Durchgangsloch im ersten Substrat und im zweiten Substrat, wobei der Randbereich jeweils ein Durchgangsloch lateral umläuft und um einen Fensterwinkel gegen eine planare Ausdehnung des ersten Substrats und des zweiten Substrats geneigt ist, wobei jeweils zwei übereinander angeordnete abgeschrägte Randbereiche in Draufsicht deckungsgleich sind und um denselben Fensterwinkel geneigt sind. In einem weiteren Verfahrensschritt S4 erfolgt ein Bereitstellen einer Fensterfolie mit einem strukturierten Fensterbereich, welcher in einer Draufsicht auf die Fensterfolie jeweils das Durchgangsloch und zumindest teilweise den zugehörigen Randbereich bedeckt. In einem weiteren Verfahrensschritt S5 erfolgt ein Positionieren der Fensterfolie zwischen der ersten Rückseite des ersten Substrats und der zweiten Vorderseite des zweiten Substrats, wobei der strukturierte Fensterbereich jeweils die abgeschrägten Randbereiche und die zugehörigen Durchgangslöcher abdeckt, und ein kraftschlüssiges Verbinden der ersten Rückseite mit der zweiten Vorderseite und der dazwischen angeordneten Fensterfolie durch einen Fügeprozess, wobei die Fensterfolie über dem jeweiligen Durchgangsloch ein um den Fensterwinkel abgeschrägtes optisches Fenster ausformt.

Bei der Vorrichtung handelt es sich vorteilhaft um eine optische Vorrichtung, vorteilhaft um einen Mikrospiegel als optisches MEMS (MOEMS). Das erste und das zweite Substrat können auch lediglich eine Verkapselung, also eine Kappe für ein optisches MEMS-Bauelement verkörpern, wobei das erste und zweite Substrat das MEMS-Bauelement überdecken können. Das erste und/oder das zweite Substrat können vorteilhaft einen Kunststoff oder ein organisches Material umfassen, beispielsweise LCP (Flüssigkristallpolymer) oder PEEK (Polyetheretherketon). Im Falle von organischen Materialien kann eine signifikante Kostenersparnis gegenüber anorganischen Materialien erzielt werden, da diese in der Verarbeitung und Beschaffung wesentlich günstiger sind. Das erste und/oder das zweite Substrat kann mittels eines Spritzgussverfahrens oder alternativ auch durch andere Verfahren hergestellt werden. Auch die Fensterfolie kann vorteilhaft ein organisches Material (etwa eine transparente Folie) umfassen und eine hohe optische Güte mit optischer Transparenz aufweisen, etwa amorphe und/oder teilkristalline Kunststoffe wie Polyethetsulphol (PES), Polycarbonat (PC), Polyacrylat (PAR), Fluorene Polyester (FPE), Polyethylen Terephtalat (PET) oder Polyethylen Naphtalat (PEN). Die Fensterfolie kann vorteilhaft auch ein dünnes Glas umfassen. Geeignete Materialien sind vorteilhaft für die anzuwendenden Prozessierungen sowie für den Betrieb der Vorrichtung geeignet, beispielsweise sondern geeignete Stoffe vorteilhaft keine schädlichen oder optisch beeinflussende Ausgasungen ab. Das erste Substrat, das zweite Substrat und/oder die Fensterfolie ergeben vorteilhaft einen ausreichenden Schutz für ein MEMS und stellen vorteilhaft eine Verkapselung für ein MEMS-Bauteil dar. Auf dem optischen Fenster kann vorteilhaft eine weitere Schicht, etwa eine optische Beschichtung angeordnet sein. Vorteilhaft kann bei einer solchen Verkapselung auf eine hermetische Verkapselung oder hermetische Abdichtung des MEMS-Bauteils durch die Verkapselung (die Substrate und das Fenster) verzichtet werden, was einen hohen Kostenvorteil mit sich bringt. Die Substrate können beispielsweise auch anorganische Materialien wie Glas oder Silizium umfassen. Ein MEMS-Bauelement, welches von der mikromechanische Vorrichtung mit geneigten optischen Fenstern überdeckt sein kann, kann durch diese Vorrichtung vorteilhaft vor Außeneinflüssen geschützt werden (Staub, Berührung) und die mikromechanische Vorrichtung kann vorteilhaft eine Kavität bilden, innerhalb welcher ein MEMS-Bauelement angeordnet werden kann (beides etwa auf einem Wafer angeordnet). Das MEMS-Bauelement kann beispielsweise mit dünnen Drähten über ein Durchgangsloch im ersten und zweiten Substrat elektrisch mit dessen Bondpads kontaktiert werden. Die mikromechanische Vorrichtung kann folglich einen Kappenwafer zur Abdeckung eines MEMS-Bauelements auf einem Wafer darstellen, einzeln oder in eine Vielzahl ausgefertigt sein und über auf einem Wafer angeordneten MEMS-Bauteilen justiert werden, über diesem angeordnet und gefügt. Als Fügen kann vorteilhaft ein anodisches Bonden oder ein Direktbonden (auch als fügemittelfreie Verbindung zwischen Glas und Silizium) über eutektische Fügeschichten sowie über Glaslote oder Kleber erfolgen.

Jedem MEMS-Bauelement, beispielsweise einem Spiegel oder einem Chip, kann genau ein optisches Fenster zugeordnet sein.

Der Fensterwinkel wird bei der Herstellung vorteilhaft so groß gewählt, dass er für ein Ablenken der störenden Reflexionen aus der Projektionsrichtung für das anzuwendende Licht ausreicht und zur Ablenkung geeignet ist.

Die Auslenkung möglicher störender Reflexionen von Grenzflächen an der Fensterfolien kann durch die schräge Stellung der optischen Fenster erzielt werden und antireflektive Beschichtungen auf dem Fenster in ihrer Wirkung signifikant unterstützen. Die antireflektiven Beschichtung dient vorteilhaft dazu, eine Transmission des Fensters zu maximieren. Da bei kleinskaligen Bauelementen ein Mikrospiegel, welchen das MEMS-Bauelement vorteilhaft umfasst und welcher parallel um seine Ruhelage schwingen kann, nur einen geringen Abstand zum ersten oder zweiten Substrat aufweisen kann, ist die schräge Stellung der Fenster eine vorteilhaft einfache Möglichkeit störende Reflexionen an der Grenzfläche des Fensters aus einer Projektionsrichtung (Abstrahlrichtung) heraus zu orientieren. Hierzu sind vorteilhaft die Fläche des optischen Fensters und eines Mikrospiegels nicht parallel zueinander.

Durch das genannte Verfahren kann vorteilhaft auch eine hermetische Verkapselung erzielt werden, je nach Art einer Fügung über einem MEMS-Bauelement oder dessen Wafer. Des Weiteren ist das Verfahren vorteilhaft serientauglich. Durch die Schrägstellung und die Randbereiche kann vorteilhaft ein Zerkratzen oder Beschädigen der optischen Fenster bei einer Anwendung oder bei einer weiteren Prozessierung vermieden oder verringert werden.

Unterschiedliche Fenster, welche zueinander lateral versetzt sein können, etwa solche im ersten und zweiten Substrat, können vorteilhaft gleiche Fensterwinkel oder jeweils unterschiedliche Fensterwinkel umfassen.

Gemäß einer bevorzugten Ausführungsform des Verfahrens wird im Verfahrensschritt S4 für das Durchgangsloch ein Trenngraben in der Fensterfolie ausgeformt, welcher in einer Draufsicht das jeweilige Durchgangsloch lateral umläuft.

Der Trenngraben kann beispielsweise in der Fensterfolie gestanzt oder mittels eines Lasers eingebracht werden, wobei der Trenngraben die Fensterfolie vorteilhaft vollständig durchdringt.

Gemäß einer bevorzugten Ausführungsform des Verfahrens durchdringt der Trenngraben außerhalb von Haltebereichen die Fensterfolie, wobei für das Durchgangsloch zwei Haltebereiche eine Drehachse beschreiben und im Verfahrensschritt S5 das optische Fenster durch ein Verdrehen der Fensterfolie um die Drehachse um den Fensterwinkel geneigt wird.

Das laterale Umlaufen ist dabei vorteilhaft durch die Haltebereiche unterbrochen.

Besteht die Fensterfolie aus Glas, können die Haltebereiche jeweils Sollbruchstellen im Glas ausbilden, welche beim Verkippen brechen können um das Fenster zu kippen. Alternativ kann die Glasfolie sowohl mit Trenngräben als auch mit bei einer Verkippung federnden und nicht brechenden Haltebereichen ausgestattet werden, etwa durch Laserätzung (laser induced deep etching). Durch die Haltebereich bleibt der Fensterbereich vorteilhaft während der Prozessierung (etwa beim Verkippen oder Verkleben) im Verbund der mikromechanischen Vorrichtung.

Gemäß einer bevorzugten Ausführungsform des Verfahrens wird im Verfahrensschritt S5 für das Verbinden ein Fügemittel als Klebematerial oder ein Glaslot im abgeschrägten Randbereich auf dem ersten Substrat und/oder auf dem zweiten Substrat und/oder auf der Fensterfolie aufgebracht.

Das Fügemittel kann auf der Fensterfolie beispielsweise durch Siebdruck aufgebracht werden. Das Klebematerial kann ein organisches Material, etwa einen thermo- oder duroplastischen Kleber, umfassen. Da das erste und/oder das zweite Substrat und die Fensterfolie auch ein anorganisches Material umfassen kann, dies ist vorteilhaft um einen hermetischen Abschluss für das MEMS-Bauelement zu erzielen, was sich zur Anwendung höherer Temperaturen beim Fügen eignen kann, können auch hermetisch abdichtende Glaslote als Fügemittel verwendet werden.

Gemäß einer bevorzugten Ausführungsform des Verfahrens wird als Fügemittel in Draufsicht auf die Fensterfolie lateral innerhalb des Trenngrabens ein das Durchgangsloch umlaufender innerer Klebepfad und/oder lateral außerhalb des Trenngrabens ein das Durchgangsloch umlaufender äußerer Klebepfad angeordnet.

Gemäß einer bevorzugten Ausführungsform des Verfahrens wird im Verfahrensschritt S5 eine Anpresskraft senkrecht auf eine planare Ausdehnung des ersten Substrats auf das erste Substrat und/oder auf das zweite Substrat ausgeübt.

Gemäß einer bevorzugten Ausführungsform des Verfahrens erfolgt beim Verbinden im Verfahrensschritt S5 ein Aushärten des Fügemittels.

Das Aushärten kann je nach angewandten Fügemittel notwendig sein oder entfallen. Ein Vorhärten des Fügemittels kann vor dem Fügen erfolgen.

Gemäß einer bevorzugten Ausführungsform des Verfahrens wird im Verfahrensschritt S4 auf der Fensterfolie ein antireflektives Material ein- oder beidseitig angeordnet.

Das antireflektive Material kann auf der Fensterfolie aufgebracht werden.

Erfindungsgemäß umfasst die mikromechanische Vorrichtung mit geneigten optischen Fenstern ein erstes Substrat mit einer ersten Vorderseite und einer ersten Rückseite und ein zweites Substrat mit einer zweiten Vorderseite und einer zweiten Rückseite, wobei das ersten Substrat mit der ersten Rückseite auf der zweiten Vorderseite auf dem zweiten Substrat angeordnet ist, wobei die erste Rückseite der zweiten Vorderseite zugewandt ist; eine Mehrzahl von Durchgangslöchern im ersten Substrat und im zweiten Substrat, wobei sich jeweils ein Durchgangsloch im ersten Substrat mit einem Durchgangsloch im zweiten Substrat deckungsgleich überdecken. Des Weiteren umfasst die Vorrichtung einen abgeschrägten Randbereich um ein jeweiliges Durchgangsloch im ersten Substrat und im zweiten Substrat, wobei der Randbereich jeweils ein Durchgangsloch lateral umläuft und im ersten Substrat und im zweiten Substrat um einen Fensterwinkel gegen eine planare Ausdehnung des ersten Substrats und des zweiten Substrats geneigt ist, wobei jeweils zwei übereinander angeordnete abgeschrägte Randbereiche in Draufsicht deckungsgleich sind und um denselben Fensterwinkel geneigt sind; und eine Fensterfolie, welche zwischen dem ersten Substrat und dem zweiten Substrat angeordnet ist und das jeweilige Durchgangsloch bedeckt und im Bereich des Durchgangslochs ein um den Fensterwinkel abgeschrägtes optisches Fenster ausformt.

Die Vorrichtung zeichnet sich vorteilhaft auch durch die in Verbindung mit dem Herstellungsverfahren genannten Merkmale aus und umgekehrt.

Gemäß einer bevorzugten Ausführungsform der Vorrichtung sind jeweils zwei übereinander angeordnete abgeschrägte Randbereiche in entgegengesetzte Richtungen abgeschrägt.

Gemäß einer bevorzugten Ausführungsform der Vorrichtung ist ein Trenngraben in der Fensterfolie ausgeformt, welcher in einer Draufsicht das jeweilige Durchgangsloch im Bereich der abgeschrägten Randbereiche lateral umläuft.

Gemäß einer bevorzugten Ausführungsform der Vorrichtung ist als Fügemittel in Draufsicht auf die Fensterfolie lateral innerhalb des Trenngrabens ein das Durchgangsloch umlaufender innerer Klebepfad und/oder lateral außerhalb des Trenngrabens ein das Durchgangsloch umlaufender äußerer Klebepfad angeordnet.

Gemäß einer bevorzugten Ausführungsform der Vorrichtung umfassen die erste Rückseite und die zweite Vorderseite jeweils Verbindungsstrukturen, durch welche das erste Substrat über dem zweiten Substrat an einer vorbestimmten Position zentrierbar ist.

Die beiden Substrate werden vorteilhaft derart gestaltet, dass diese beim Zusammendrücken selbstzentrierend für eine genau bestimmte Position übereinander wirken können. Mittels Verbindungsstrukturen kann eine solche Zentrierung vorteilhaft beim Zusammendrücken automatisch und genau erfolgen.

Gemäß einer bevorzugten Ausführungsform der Vorrichtung ist auf der Fensterfolie ein antireflektives Material ein- oder beidseitig angeordnet.

Weitere Merkmale und Vorteile von Ausführungsformen der Erfindung ergeben sich aus der nachfolgenden Beschreibung mit Bezug auf die beigefügten Zeichnungen.

### Kurze Beschreibung der Zeichnungen

Die vorliegende Erfindung wird nachfolgend anhand der in den schematischen Figuren der Zeichnung angegebenen Ausführungsbeispiele näher erläutert.

Es zeigen:
- Fig. 1: eine schematische Darstellung eines ersten und eines zweiten Substrats während des Herstellungsverfahrens für eine mikromechanische Vorrichtung;
- Fig. 2: eine schematische Draufsicht auf eine Fensterfolie für eine Vorrichtung gemäß der vorliegenden Erfindung;
- Fig. 3: eine schematische Seitenansicht einer Abfolge des Herstellungsverfahrens und der Vorrichtung gemäß einer Ausführungsform der vorliegenden Erfindung; und
- Fig. 4: eine schematische Darstellung einer Abfolge von Verfahrensschritten gemäß eines Ausführungsbeispiels der vorliegenden Erfindung.

In den Figuren bezeichnen gleiche Bezugszeichen gleiche bzw. funktionsgleiche Elemente.

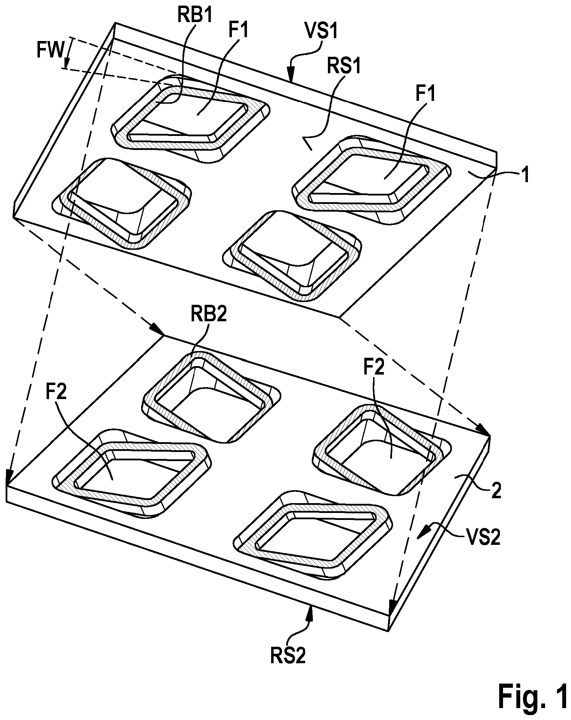

Fig. 1 zeigt eine schematische Darstellung eines ersten und eines zweiten Substrats während des Herstellungsverfahrens für eine mikromechanische Vorrichtung.

Die Vorrichtung umfasst eine Mehrzahl von Durchgangslöchern F1, F2 im ersten Substrat S1 und im zweiten Substrat 2, wobei sich jeweils ein Durchgangsloch F1 im ersten Substrat 1 mit einem Durchgangsloch F2 im zweiten Substrat 2 deckungsgleich überdecken, wenn diese übereinander angeordnet werden. Die Substrate umfassen einen abgeschrägten Randbereich RB1, RB2 um ein jeweiliges Durchgangsloch F1, F2 im ersten Substrat 1 und im zweiten Substrat 2, wobei der Randbereich RB1, RB2 jeweils ein Durchgangsloch F1, F2 lateral umläuft und im ersten Substrat 1 und im zweiten Substrat 2 um einen Fensterwinkel FW gegen eine planare Ausdehnung des ersten Substrats 1 und des zweiten Substrats 2 geneigt ist, wobei jeweils zwei übereinander angeordnete abgeschrägte Randbereiche RB1, RB2 in Draufsicht deckungsgleich sind und um denselben Fensterwinkel FW geneigt sind. Hierbei stellt ein Randbereich RB1 vorteilhaft das zum Draufstecken notwendige Gegenstück zum anderen Randbereich RB2 des zugehörigen Durchgangslochs dar. Das erste Substrat 1 und das zweite Substrat 2 werden vorteilhaft gemäß der Pfeildarstellung der Fig. 1 übereinander angeordnet, wobei eine erste Rückseite RS1 auf einer zweiten Vorderseite VS2 angeordnet wird.

Der Randbereich RB1, RB2 im ersten und im zweiten Substrat ist jeweils vorteilhaft in einem Teilbereich gegenüber der planaren Ausdehnung des Substrats erhaben und in einem anderen Teilbereich abgesenkt. Die erhabenen Bereiche im ersten Substrat 1 passen vorteilhaft genau in die abgesenkten Teilbereiche des zweiten Substrats 2 und umgekehrt.

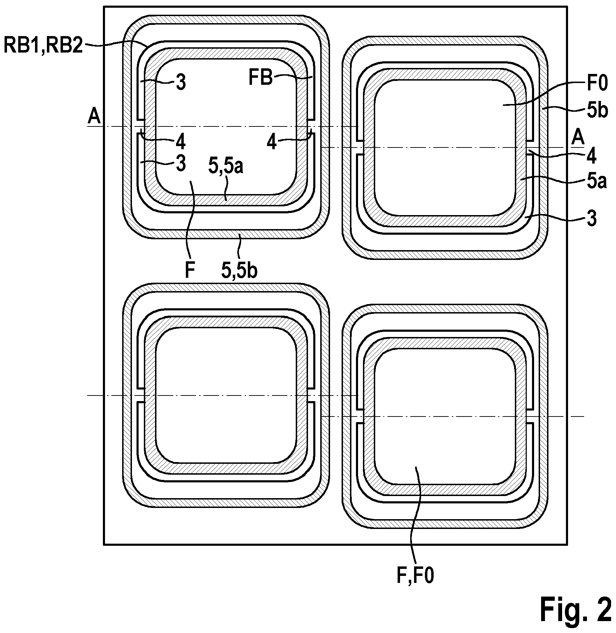

Fig. 2 zeigt eine schematische Draufsicht auf eine Fensterfolie für eine Vorrichtung gemäß der vorliegenden Erfindung.

Die Fensterfolie FO der Vorrichtung wird mit einer Strukturierung versehen, welche im Fensterbereich FB einen Trenngraben 3 umfassen kann. Dieser Trenngraben 3 umläuft den Bereich des Durchgangslochs, über welchen die Fensterfolie FO während des Verfahrens positioniert wird, lateral an einer Außenseite und vorteilhaft im Bereich der abgeschrägten Randbereiche RB1 und RB2. Das laterale Umlaufen durch den Trenngraben 3 kann an den Haltebereichen 4 unterbrochen sein.

Für ein oder jedes Durchgangsloch in beiden Substraten kann die Fensterfolie FO zwei Haltebereiche 4 umfassen, welche den Trenngraben 3 in zwei Bereiche unterteilen. Die Haltebereiche 4 definieren vorteilhaft eine Drehachse A. Beim aufeinander Anordnen beider Substrate mit der Fensterfolie FO dazwischen kann das optische Fenster schräg gestellt werden, wobei beim Auflegen auf die abgeschrägten Randbereiche RB1 und RB2 diese das optische Fenster F durch ein Verdrehen der Fensterfolie FO um die Drehachse A die Fensterfolie FO um den Fensterwinkel neigen können.

Auf der Fensterfolie FO oder auf einem der Substrate kann ein Fügemittel 5 als Klebematerial oder ein Glaslot im Randbereich RB1 und RB2 angeordnet sein.

Das Fügemittel 5 kann in Draufsicht auf die Fensterfolie FO lateral innerhalb des Trenngrabens 3 einen das Durchgangsloch umlaufenden inneren Klebepfad 5a und/oder lateral außerhalb des Trenngrabens 3 einen das Durchgangsloch umlaufenden äußeren Klebepfad 5b bilden. Das Durchgangsloch kann einer Position eines Chips als MEMS-Bauelement auf einem Wafer entsprechen, wodurch der äußere Klebepfad 5b einer äußeren Kontur des Chips entsprechen kann. Der äußere Klebepfad 5b dient vorteilhaft zu einer Abdichtung des Innenbereichs, also der MEMS-Bauelemente, nach außen, etwa als Schutz gegen Sägewasser beim Vereinzeln des Wafers.

Durch ein Aushärten des Fügemittels kann vorteilhaft der gekippte Zustand des Fensters und der zusammengesetzten Substrate dauerhaft eingenommen werden. Beim Verwenden von Glasloten kann bei hohen Temperaturen das Lot erweichen, die Fügeelemente (Substrate und Fensterfolie) benetzen und nach einem Abkühlen eine feste hermetische Verbindung ergeben.

Benachbarte Fenster F können in Draufsicht auf das Substrat lateral zueinander versetzt oder in gleicher Linie angeordnet sein.

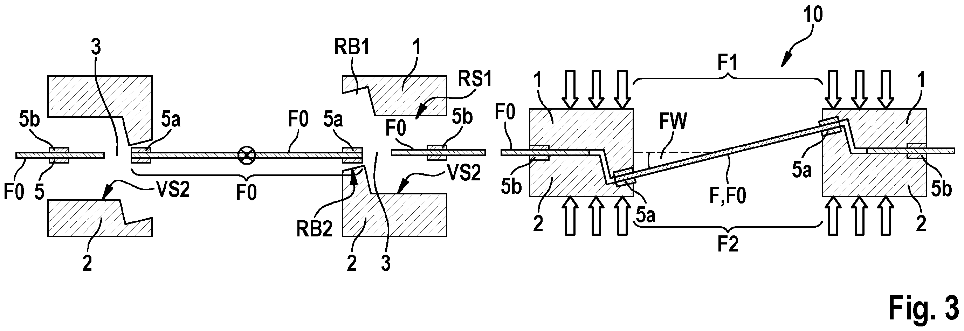

Fig. 3 zeigt eine schematische Seitenansicht einer Abfolge des Herstellungsverfahrens und der Vorrichtung gemäß einer Ausführungsform der vorliegenden Erfindung.

Das linke Bild der Fig. 3 zeigt eine Anordnung der Fensterfolie FO in einem Querschnitt zwischen dem ersten Substrat 1 und dem zweiten Substrat 2. Die Fensterfolie FO ist hierbei mit dem Trenngraben 3 im Bereich der Randbereiche RB1 und RB2 gezeigt. Außerhalb des Trenngrabens 3 ist das Fügemittel 5 als äußerer Klebepfad 5b und als inneren Klebepfad 5a vorteilhaft auf beiden Seiten der Fensterfolie FO gezeigt.

Im rechten Bild wird die fertiggestellte Vorrichtung 10 im Querschnitt gezeigt.

Eine mikromechanische Vorrichtung 10 mit geneigten optischen Fenstern F, umfasst ein erstes Substrat 1 mit einer ersten Vorderseite VS1 und einer ersten Rückseite RS1 und ein zweites Substrat 2 mit einer zweiten Vorderseite VS2 und einer zweiten Rückseite RS2, wobei das ersten Substrat 1 mit der ersten Rückseite RS1 auf der zweiten Vorderseite VS2 auf dem zweiten Substrat 2 angeordnet ist, wobei die erste Rückseite RS1 der zweiten Vorderseite VS2 zugewandt ist.

Die Fensterfolie FO, welche zwischen dem ersten Substrat 1 und dem zweiten Substrat 2 angeordnet ist und das jeweilige Durchgangsloch F1, F2 bedeckt, kann im Bereich des Durchgangslochs F1, F2 ein um den Fensterwinkel FW abgeschrägtes optisches Fenster F ausformen. Die beiden Substrate können durch eine Anpresskraft aneinander gedrückt werden (Pfeildarstellung), was zu einem Verkippen und Fixieren des optischen Fensters an den Randbereichen RB1 und RB2 beim Zusammendrücken führen kann.

Da die Fensterfolie(n) innerhalb der beiden gestapelten Substrate angeordnet ist/sind, können diese bei weiterer Prozessierung der Vorrichtung vor mechanischer Berührung, welche zu Defekten und Kratzern führen kann, geschützt werden.

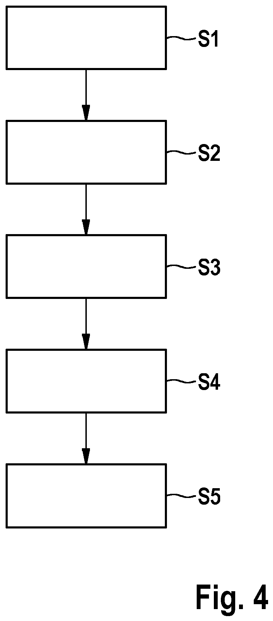

Fig. 4 zeigt eine schematische Darstellung einer Abfolge von Verfahrensschritten gemäß eines Ausführungsbeispiels der vorliegenden Erfindung.

Beim Herstellungsverfahren für eine mikromechanische Vorrichtung mit geneigten optischen Fenstern, erfolgt in einem Verfahrensschritt S1 ein Bereitstellen eines ersten Substrats mit einer ersten Vorderseite und einer ersten Rückseite und eines zweiten Substrats mit einer zweiten Vorderseite und einer zweiten Rückseite; in einem Verfahrensschritt S2 erfolgt ein Erzeugen einer Mehrzahl von Durchgangslöchern im ersten Substrat und im zweiten Substrat derart, dass zu jedem Durchgangsloch im ersten Substrat ein deckungsgleiches Durchgangsloch im zweiten Substrat erzeugt wird, welche sich überdecken wenn das erste Substrat über dem zweiten Substrat angeordnet wird, wobei die erste Rückseite der zweiten Vorderseite zugewandt ist. In einem Verfahrensschritt S3 erfolgt ein Erzeugen eines abgeschrägten Randbereichs um ein jeweiliges Durchgangsloch im ersten Substrat und im zweiten Substrat, wobei der Randbereich jeweils ein Durchgangsloch lateral umläuft und um einen Fensterwinkel gegen eine planare Ausdehnung des ersten Substrats und des zweiten Substrats geneigt ist, wobei jeweils zwei übereinander angeordnete abgeschrägte Randbereiche in Draufsicht deckungsgleich sind und um denselben Fensterwinkel geneigt sind. In einem Verfahrensschritt S3 erfolgt ein Bereitstellen einer Fensterfolie mit einem strukturierten Fensterbereich, welcher in einer Draufsicht auf die Fensterfolie jeweils das Durchgangsloch und zumindest teilweise den zugehörigen Randbereich bedeckt; und in einem Verfahrensschritt S5 erfolgt ein Positionieren der Fensterfolie zwischen der ersten Rückseite des ersten Substrats und der zweiten Vorderseite des zweiten Substrats, wobei der strukturierte Fensterbereich jeweils die abgeschrägten Randbereiche und die zugehörigen Durchgangslöcher abdeckt, und ein kraftschlüssiges Verbinden der ersten Rückseite mit der zweiten Vorderseite und der dazwischen angeordneten Fensterfolie durch einen Fügeprozess, wobei die Fensterfolie über dem jeweiligen Durchgangsloch ein um den Fensterwinkel abgeschrägtes optisches Fenster ausformt. Das Verfahren kann in der beschriebenen Reihenfolge erfolgen, die genannten Verfahrensschritte können jedoch auch in einer anderen Abfolge durchgeführt werden.

Obwohl die vorliegende Erfindung anhand des bevorzugten Ausführungsbeispiels vorstehend vollständig beschrieben wurde, ist sie darauf nicht beschränkt, sondern auf vielfältige Art und Weise modifizierbar.

## Patentansprüche

1. Herstellungsverfahren für eine mikromechanische Vorrichtung (10) mit geneigten optischen Fenstern (F), welches die Schritte aufweist:
S1) Bereitstellen eines ersten Substrats (1) mit einer ersten Vorderseite (VS1) und einer ersten Rückseite (RS1) und eines zweiten Substrats (2) mit einer zweiten Vorderseite (VS2) und einer zweiten Rückseite (RS2);
S2) Erzeugen einer Mehrzahl von Durchgangslöchern (F1, F2) im ersten Substrat (S1) und im zweiten Substrat (2) derart, dass zu jedem Durchgangsloch (F1) im ersten Substrat (1) ein deckungsgleiches Durchgangsloch (F2) im zweiten Substrat (2) erzeugt wird, welche sich überdecken wenn das erste Substrat (1) über dem zweiten Substrat (2) angeordnet wird, wobei die erste Rückseite (RS1) der zweiten Vorderseite (VS2) zugewandt ist;
S3) Erzeugen eines abgeschrägten Randbereichs (RB1, RB2) um ein jeweiliges Durchgangsloch (F1, F2) im ersten Substrat (1) und im zweiten Substrat (2), wobei der Randbereich (RB1, RB2) jeweils ein Durchgangsloch (F1, F2) lateral umläuft und um einen Fensterwinkel (FW) gegen eine planare Ausdehnung des ersten Substrats (1) und des zweiten Substrats (2) geneigt ist, wobei jeweils zwei übereinander angeordnete abgeschrägte Randbereiche (RB1, RB2) in Draufsicht deckungsgleich sind und um denselben Fensterwinkel (FW) geneigt sind;
S4) Bereitstellen einer Fensterfolie (FO) mit einem strukturierten Fensterbereich (FB), welcher in einer Draufsicht auf die Fensterfolie (FO) jeweils das Durchgangsloch (F1, F2) und zumindest teilweise den zugehörigen Randbereich (RB1, RB2) bedeckt; und
S5) Positionieren der Fensterfolie (FO) zwischen der ersten Rückseite (RS1) des ersten Substrats (1) und der zweiten Vorderseite (VS2) des zweiten Substrats (2), wobei der strukturierte Fensterbereich (FB) jeweils die abgeschrägten Randbereiche (RB1, RB2) und die zugehörigen Durchgangslöcher (F1, F2) abdeckt, und kraftschlüssiges Verbinden der ersten Rückseite (RS1) mit der zweiten Vorderseite (VS2) und der dazwischen angeordneten Fensterfolie (FO) durch einen Fügeprozess, wobei die Fensterfolie (FO) über dem jeweiligen Durchgangsloch (F1, F2) ein um den Fensterwinkel (FW) abgeschrägtes optisches Fenster (F) ausformt.

2. Herstellungsverfahren nach Anspruch 1, wobei im Verfahrensschritt S4 für das Durchgangsloch (F1, F2) ein Trenngraben (3) in der Fensterfolie (FO) ausgeformt wird, welcher in einer Draufsicht das jeweilige Durchgangsloch (F1, F2) lateral umläuft.

3. Herstellungsverfahren nach Anspruch 2, wobei der Trenngraben (3) außerhalb von Haltebereichen (4) die Fensterfolie (FO) durchdringt, wobei für das Durchgangsloch (F1, F2) zwei Haltebereiche (4) eine Drehachse (A) beschreiben und im Verfahrensschritt S5 das optische Fenster (F) durch ein Verdrehen der Fensterfolie (FO) um die Drehachse (A) um den Fensterwinkel (FW) geneigt wird.

4. Herstellungsverfahren nach einem der Ansprüche 1 bis 3, wobei im Verfahrensschritt S5 für das Verbinden ein Fügemittel (5) als Klebematerial oder ein Glaslot im abgeschrägten Randbereich (RB1, RB2) auf dem ersten Substrat (1) und/oder auf dem zweiten Substrat (2) und/oder auf der Fensterfolie (FO) aufgebracht wird.

5. Herstellungsverfahren nach Anspruch 4, wobei als Fügemittel in Draufsicht auf die Fensterfolie (FO) lateral innerhalb des Trenngrabens (3) ein das Durchgangsloch (F1, F2) umlaufender innerer Klebepfad (5a) und/oder lateral außerhalb des Trenngrabens (3) ein das Durchgangsloch (F1, F2) umlaufender äußerer Klebepfad (5b) angeordnet wird.

6. Herstellungsverfahren nach einem der Ansprüche 1 bis 5, wobei im Verfahrensschritt S5 eine Anpresskraft senkrecht auf eine planare Ausdehnung des ersten Substrats (1) auf das erste Substrat (1) und/oder auf das zweite Substrat (2) ausgeübt wird.

7. Herstellungsverfahren nach einem der Ansprüche 1 bis 6, soweit rückbezogen auf Anspruch 4, bei dem beim Verbinden im Verfahrensschritt S5 ein Aushärten des Fügemittels erfolgt.

8. Herstellungsverfahren nach einem der Ansprüche 1 bis 7, wobei im Verfahrensschritt S4 auf der Fensterfolie (FO) ein antireflektives Material ein- oder beidseitig angeordnet wird.

9. Mikromechanische Vorrichtung (10) mit geneigten optischen Fenstern (F), mit:
einem ersten Substrat (1) mit einer ersten Vorderseite (VS1) und einer ersten Rückseite (RS1) und einem zweiten Substrat (2) mit einer zweiten Vorderseite (VS2) und einer zweiten Rückseite (RS2), wobei das ersten Substrat (1) mit der ersten Rückseite (RS1) auf der zweiten Vorderseite (VS2) auf dem zweiten Substrat (2) angeordnet ist, wobei die erste Rückseite (RS1) der zweiten Vorderseite (VS2) zugewandt ist;
einer Mehrzahl von Durchgangslöchern (F1, F2) im ersten Substrat (S1) und im zweiten Substrat (2), wobei sich jeweils ein Durchgangsloch (F1) im ersten Substrat (1) mit einem Durchgangsloch (F2) im zweiten Substrat (2) deckungsgleich überdecken;
einem abgeschrägten Randbereich (RB1, RB2) um ein jeweiliges Durchgangsloch (F1, F2) im ersten Substrat (1) und im zweiten Substrat (2), wobei der Randbereich (RB1, RB2) jeweils ein Durchgangsloch (F1, F2) lateral umläuft und im ersten Substrat (1) und im zweiten Substrat (2) um einen Fensterwinkel (FW) gegen eine planare Ausdehnung des ersten Substrats (1) und des zweiten Substrats (2) geneigt ist, wobei jeweils zwei übereinander angeordnete abgeschrägte Randbereiche (RB1, RB2) in Draufsicht deckungsgleich sind und um denselben Fensterwinkel (FW) geneigt sind;
einer Fensterfolie (FO), welche zwischen dem ersten Substrat (1) und dem zweiten Substrat (2) angeordnet ist und das jeweilige Durchgangsloch (F1, F2) bedeckt und im Bereich des Durchgangslochs (F1, F2) ein um den Fensterwinkel (FW) abgeschrägtes optisches Fenster (F) ausformt.

10. Mikromechanische Vorrichtung nach Anspruch 9, wobei jeweils zwei übereinander angeordnete abgeschrägte Randbereiche (RB1, RB2) in entgegengesetzte Richtungen abgeschrägt sind.

11. Mikromechanische Vorrichtung nach einem der Ansprüche 9 oder 10, bei welcher ein Trenngraben (3) in der Fensterfolie (FO) ausgeformt ist, welcher in einer Draufsicht das jeweilige Durchgangsloch (F1, F2) im Bereich der abgeschrägten Randbereiche (RB1, RB2) lateral umläuft.

12. Mikromechanische Vorrichtung nach Anspruch 11, bei welcher als Fügemittel in Draufsicht auf die Fensterfolie (FO) lateral innerhalb des Trenngrabens (3) ein das Durchgangsloch (F1, F2) umlaufender innerer Klebepfad (5a) und/oder lateral außerhalb des Trenngrabens (3) ein das Durchgangsloch (F1, F2) umlaufender äußerer Klebepfad (5b) angeordnet ist.

13. Mikromechanische Vorrichtung nach einem der Ansprüche 9 bis 12, bei welcher die erste Rückseite (RS1) und die zweite Vorderseite (VS2) jeweils Verbindungsstrukturen umfassen, durch welche das erste Substrat (1) über dem zweiten Substrat (2) an einer vorbestimmten Position zentrierbar ist.

14. Mikromechanische Vorrichtung nach einem der Ansprüche 9 bis 13, bei welcher auf der Fensterfolie (FO) ein antireflektives Material ein- oder beidseitig angeordnet ist.

## Claims

1. Method for producing a micromechanical device (10) with inclined optical windows (F), which comprises the steps of:
S1) providing a first substrate (1) having a first front side (VS1) and a first rear side (RS1) and a second substrate (2) having a second front side (VS2) and a second rear side (RS2);
S2) creating a plurality of through-holes (F1, F2) in the first substrate (S1) and in the second substrate (2) in such a way that a congruent through-hole (F2) is created in the second substrate (2) in relation to each through-hole (F1) in the first substrate (1), said through-holes covering over one another when the first substrate (1) is arranged over the second substrate (2), with the first rear side (RS1) facing the second front side (VS2);
S3) creating a slanted edge region (RB1, RB2) around a respective through-hole (F1, F2) in the first substrate (1) and in the second substrate (2), wherein the edge region (RB1, RB2) in each case runs laterally around a through-hole (F1, F2) and is inclined by a window angle (FW) with respect to a planar extent of the first substrate (1) and the second substrate (2), wherein two slanted edge regions (RB1, RB2) that are arranged one over the other are in each case congruent in plan view and are inclined by the same window angle (FW);
S4) providing a window film (FO) having a structured window region (FB), which in a plan view of the window film (FO) in each case covers the through-hole (F1, F2) and at least partially the associated edge region (RB1, RB2); and
S5) positioning the window film (FO) between the first rear side (RS1) of the first substrate (1) and the second front side (VS2) of the second substrate (2), wherein the structured window region (FB) in each case covers the slanted edge regions (RB1, RB2) and the associated through-holes (F1, F2), and connecting the first rear side (RS1) to the second front side (VS2) and the window film (FO) arranged in between in a nonpositive manner by a joining process, wherein the window film (FO) forms over the respective through-hole (F1, F2) an optical window (F) slanted by the window angle (FW).

2. Production method according to Claim 1, wherein, in method step S4, a separating trench (3) which in a plan view runs laterally around the respective through-hole (F1, F2) is formed in the window film (FO) for the through-hole (F1, F2).

3. Production method according to Claim 2, wherein the separating trench (3) penetrates the window film (FO) outside holding regions (4), wherein two holding regions (4) describe an axis of rotation (A) for the through-hole (F1, F2) and, in method step S5, the optical window (F) is inclined by the window angle (FW) by turning of the window film (FO) about the axis of rotation (A).

4. Production method according to one of Claims 1 to 3, wherein, in method step S5, for the connecting process a joining means (5) is supplied as a bonding material or a glass solder in the slanted edge region (RB1, RB2) on the first substrate (1) and/or on the second substrate (2) and/or on the window film (FO).

5. Production method according to Claim 4, wherein, in plan view of the window film (FO), an inner bonding path (5a) running around the through-hole (F1, F2) is arranged laterally inside the separating trench (3) and/or an outer bonding path (5b) running around the through-hole (F1, F2) is arranged laterally outside the separating trench (3) as joining means.

6. Production method according to one of Claims 1 to 5, wherein, in method step S5, a pressing force is exerted on the first substrate (1) and/or on the second substrate (2) perpendicularly to a planar extent of the first substrate (1).

7. Production method according to one of Claims 1 to 6, insofar as they refer back to Claim 4, in which a curing of the joining means takes place during the connecting process in method step S5.

8. Production method according to one of Claims 1 to 7, wherein, in method step S4, an antireflective material is arranged on one or both sides of the window film (FO).

9. Micromechanical device (10) with inclined optical windows (F), comprising:
a first substrate (1) having a first front side (VS1) and a first rear side (RS1) and a second substrate (2) having a second front side (VS2) and a second rear side (RS2), wherein the first substrate (1) is arranged with the first rear side (RS1) on the second front side (VS2) on the second substrate (2), with the first rear side (RS1) facing the second front side (VS2);
a plurality of through-holes (F1, F2) in the first substrate (S1) and in the second substrate (2), wherein in each case a through-hole (F1) in the first substrate (1) congruently covers over a through-hole (F2) in the second substrate (2);
a slanted edge region (RB1, RB2) around a respective through-hole (F1, F2) in the first substrate (1) and in the second substrate (2), wherein the edge region (RB1, RB2) in each case runs laterally around a through-hole (F1, F2) and in the first substrate (1) and in the second substrate (2) is inclined by a window angle (FW) with respect to a planar extent of the first substrate (1) and the second substrate (2), wherein two slanted edge regions (RB1, RB2) that are arranged one over the other are in each case congruent in plan view and are inclined by the same window angle (FW);
a window film (FO), which is arranged between the first substrate (1) and the second substrate (2) and covers the respective through-hole (F1, F2) and forms in the region of the through-hole (F1, F2) an optical window (F) slanted by the window angle (FW).

10. Micromechanical device according to Claim 9, wherein two slanted edge regions (RB1, RB2) that are arranged one over the other are in each case slanted in opposite directions.

11. Micromechanical device according to either of Claims 9 and 10, in which a separating trench (3) which in a plan view runs laterally around the respective through-hole (F1, F2) in the region of the slanted edge regions (RB1, RB2) is formed in the window film (FO).

12. Micromechanical device according to Claim 11, in which, in plan view of the window film (FO), an inner bonding path (5a) running around the through-hole (F1, F2) is arranged laterally inside the separating trench (3) and/or an outer bonding path (5b) running around the through-hole (F1, F2) is arranged laterally outside the separating trench (3) as joining means.

13. Micromechanical device according of Claims 9 to 12, in which the first rear side (RS1) and the second front side (VS2) in each case comprise connecting structures by which the first substrate (1) can be centred over the second substrate (2) at a predetermined position.

14. Micromechanical device according to one of Claims 9 to 13, in which an antireflective material is arranged on one or both sides of the window film (FO).

## Revendications

1. Procédé de fabrication d'un dispositif micromécanique (10) pourvu de fenêtres optiques inclinées (F), ledit procédé comprenant les étapes suivantes :
S1) fournir un premier substrat (1) pourvu d'une première face avant (VS1) et d'une première face arrière (RS1) et un deuxième substrat (2) pourvu d'une deuxième face avant (VS2) et d'une deuxième face arrière (RS2) ; S2) générer une pluralité de trous traversants (F1, F2) dans le premier substrat (S1) et dans le deuxième substrat (2) de sorte que pour chaque trou traversant (F1) du premier substrat (1) un trou traversant coïncident (F2) est généré dans le deuxième substrat (2), lesquels trous se chevauchent lorsque le premier substrat (1) est placé sur le deuxième substrat (2), la première face arrière (RS1) étant dirigée vers la deuxième face avant (VS2) ;
S3) générer une zone de bord biseauté (RB1, RB2) autour d'un trou traversant respectif (F1, F2) dans le premier substrat (1) et dans le deuxième substrat (2), la zone de bord (RB1, RB2) s'étendant à chaque fois latéralement autour d'un trou traversant (F1, F2) et étant inclinée d'un angle de fenêtre (FW) vers une extension plane du premier substrat (1) et du deuxième substrat (2), deux zones de bord biseautées (RB1, RB2) disposées l'une au-dessus de l'autre étant à chaque fois en coïncidence en vue de dessus et inclinées du même angle de fenêtre (FW) ;
S4) fournir un film de fenêtre (FO) pourvu d'une zone de fenêtre structurée (FB) qui, dans une vue de dessus du film de fenêtre (FO), recouvre le trou traversant respectif (F1, F2) et au moins partiellement la zone de bord associée (RB1, RB2) ; et
S5) positionner le film de fenêtre (FO) entre la première face arrière (RS1) du premier substrat (1) et la deuxième face avant (VS2) du deuxième substrat (2), la zone de fenêtre structurée (FB) recouvrant chacune les zones de bord biseautées (RB1, RB2) et les trous traversants associés (F1, F2), et relier en force la première face arrière (RS1) à la deuxième face avant (VS2) et au film de fenêtre (FO) disposé entre elles par un processus d'assemblage, le film de fenêtre (FO) sur le trou traversant respectif (F1, F2) formant une fenêtre optique (F) qui est biseautée de l'angle de fenêtre (FW).

2. Procédé de fabrication selon la revendication 1, à l'étape de procédé S4, pour le trou traversant (F1, F2), une tranchée de séparation (3), qui s'étend en vue de dessus latéralement autour du trou traversant respectif (F1, F2), étant ménagée dans le film de fenêtre (FO).

3. Procédé de fabrication selon la revendication 2, la tranchée de séparation (3) pénétrant dans le film de fenêtre (FO) à l'extérieur des zones de retenue (4), deux zones de retenue (4) décrivant un axe de rotation (A) pour le trou traversant (F1, F2) et, à l'étape de procédé S5, la fenêtre optique (F) étant inclinée de l'angle de fenêtre (FW) par torsion du film de fenêtre (FO) sur l'axe de rotation (A).

4. Procédé de fabrication selon l'une des revendications 1 à 3, à l'étape de procédé S5, pour effectuer la liaison, un agent d'assemblage (5) tel qu'une matière adhésive ou une brasure de verre étant appliqué dans la zone de bord biseautée (RB1, RB2) sur le premier substrat (1) et/ou sur le deuxième substrat (2) et/ou sur le film de fenêtre (FO).

5. Procédé de fabrication selon la revendication 4, un chemin de collage intérieur (5a) qui s'étend autour du trou traversant (F1, F2) étant disposé latéralement à l'intérieur de la tranchée de séparation (3), et/ou un chemin de collage extérieur (5b) qui s'étend autour du trou traversant (F1, F2) étant disposé latéralement à l'extérieur de la tranchée de séparation (3), comme agent d'assemblage dans une vue de dessus du film de fenêtre (FO) .

6. Procédé de fabrication selon l'une des revendications 1 à 5, à l'étape de procédé S5 une force de pressage étant exercée sur le premier substrat (1) et/ou sur le deuxième substrat (2) perpendiculairement à une extension plane du premier substrat (1).

7. Procédé de fabrication selon l'une des revendications 1 à 6, dans la mesure où elle dépend de la revendication 4, dans lequel l'agent d'assemblage est durci lors de la liaison à l'étape de procédé S5.

8. Procédé de fabrication selon l'une des revendications 1 à 7, à l'étape de procédé S4 une matière antireflet étant disposée sur une face ou sur les deux faces du film de fenêtre (FO).

9. Dispositif micromécanique (10) pourvu de fenêtres optiques inclinées (F), ledit dispositif comprenant :
un premier substrat (1) pourvu d'une première face avant (VS1) et d'une première face arrière (RS1) et un deuxième substrat (2) pourvu d'une deuxième face avant (VS2) et d'une deuxième face arrière (RS2), le premier substrat (1) pourvu de la première face arrière (RS1) étant disposé sur la deuxième face avant (VS2) du deuxième substrat (2), la première face arrière (RS1) étant dirigée vers la deuxième face avant (VS2) ;
une pluralité de trous traversants (F1, F2) ménagés dans le premier substrat (S1) et dans le deuxième substrat (2), un trou traversant (F1) ménagé dans le premier substrat (1) recouvrant en coïncidence un trou traversant (F2) ménagé dans le deuxième substrat (2) ;
une zone de bord biseautée (RB1, RB2) autour d'un trou traversant respectif (F1, F2) ménagé dans le premier substrat (1) et dans le deuxième substrat (2), la zone de bord (RB1, RB2) s'étendant latéralement autour d'un trou traversant respectif (F1, F2) et étant inclinée d'un angle de fenêtre (FW) vers une extension plane du premier substrat (1) et du deuxième substrat (2) dans le premier substrat (1) et dans le deuxième substrat (2), deux zones de bord biseautées (RB1, RB2) étant disposées en coïncidence dans une vue de dessus et étant inclinées du même angle de fenêtre (FW) ;
un film de fenêtre (FO), qui est disposé entre le premier substrat (1) et le deuxième substrat (2), qui recouvre le trou traversant respectif (F1, F2) et qui forme dans la zone du trou traversant (F1, F2) une fenêtre optique (F) qui est biseautée de l'angle de fenêtre (FW).

10. Dispositif micromécanique selon la revendication 9, deux zones de bord biseautées (RB1, RB2) qui sont disposées l'une au-dessus de l'autre étant biseautées à chaque fois dans des directions opposées.

11. Dispositif micromécanique selon l'une des revendications 9 et 10, dans lequel une tranchée de séparation (3) étant ménagée dans le film de fenêtre (FO) qui s'étend latéralement, dans une vue de dessus, autour du trou traversant respectif (F1, F2) au niveau des zones de bord biseautées (RB1, RB2).

12. Dispositif micromécanique selon la revendication 11, dans lequel un chemin de collage intérieur (5a) qui s'étend autour du trou traversant (F1, F2) étant disposé latéralement à l'intérieur de la tranchée de séparation (3), et/ou un chemin de collage extérieur (5b) qui s'étend autour du trou traversant (F1, F2) étant disposé latéralement à l'extérieur de la tranchée de séparation (3), comme agent d'assemblage dans une vue de dessus du film de fenêtre (FO).

13. Dispositif micromécanique selon l'une des revendications 9 à 12, dans lequel la première face arrière (RS1) et la deuxième face avant (VS2) comportent chacune des structures de liaison permettant de centrer le premier substrat (1) sur le deuxième substrat (2) à une position prédéterminée.

14. Dispositif micromécanique selon l'une des revendications 9 à 13, dans lequel une matière antireflet est disposée sur une face ou sur les deux faces du film de fenêtre (FO).
